# EUROPÄISCHE PATENTSCHRIFT

(11) **EP 1 099 300 B1**
(45) Veröffentlichungstag und Bekanntmachung des Hinweises auf die Patenterteilung: **21.05.2003**
(21) Anmeldenummer: 99945843.3
(22) Anmeldetag: 01.07.1999
(51) Int. Cl.: H03F 1/02

(54) **SCHALTUNGSANORDNUNG ZUM ERZEUGEN EINER HILFSGLEICHSPANNUNG**
CIRCUIT FOR GENERATING AN AUXILIARY DIRECT CURRENT VOLTAGE
CIRCUIT POUR PRODUIRE UNE TENSION CONTINUE AUXILIAIRE

(30) Priorität: 14.07.1998 DE 19831561
(43) Veröffentlichungstag der Anmeldung: 16.05.2001
(73) Patentinhaber: Infineon Technologies AG, 81669 München (DE)
(72) Erfinder: MEIER, Thomas, D-80992 München (DE)
(74) Vertreter: Zimmermann & Partner
(86) Internationale Anmeldenummer: DE9901972
(87) Internationale Veröffentlichungsnummer: WO00004635

(56) Entgegenhaltungen:
- EP-A- 0 829 954
- WO-A-98/25339
- US-A- 5 543 976

## Beschreibung

Die Erfindung betrifft eine Schaltungsanordnung zum Erzeugen einer Hilfsgleichspannung aus einer Versorgungsspannung für einen ein hochfrequentes Nutzsignal führenden Schaltungsteil.

In Höchstfrequenzverstärkern üblicherweise eingesetzte Mes-Feldeffekttransistoren etwa auf Gallium-Arsenid-Basis benötigen zur Einstellung des Arbeitspunktes eine negative Spannung am Gate. Insbesondere bei Verstärkern mit hoher Leistung ist diese Spannung zur Erreichung eines hohen Wirkungsgrades notwendig. Da in vielen, beispielsweise batteriebetriebenen Geräten ansonsten keine negative Spannung in der Regel benötigt wird, ist eine Erzeugung dieser negativen Spannung auf dem Verstärkerchip selbst wünschenswert.

Es können dazu freilaufende Oszillatoren auf dem Chip oder bereits verfügbare Taktsignale auf dem Chip verwendet werden. Aufgrund der festen Frequenzen werden jedoch in beiden Fällen unerwünschte Spektrallinien erzeugt, die mit erheblichem Aufwand unterdrückt werden müssen, um Systemanforderungen und Abstrahlrichtlinien zu erfüllen.

Eine Schaltungsanordnung zur Erzeugung eines Gleichstromruhestroms eines Hochfrequentverstärkers in Abhängigkeit von einem hochfrequenten Eingangssignal ist z.B. aus der WO98/25339 bekannt. Die Schaltungsanordnung umfaßt dabei eine erste Verstärkerstufe, deren Eingang über eine Diode mit dem hochfrequenten Signal beaufschlagt ist. Durch eine Vielzahl von zwischen Eingang des Verstärkers und Masse geschalteten Kondensatoren wird das Eingangssignal geglättet, so daß niederfrequentere Veränderungen des Eingangssignals zur Kompensation von Veränderungen des Kollektorstroms des Hochfrequentverstärkes herangezogen werden kann.

Aufgabe der vorliegenden Erfindung ist es, eine Schaltungsanordnung der eingangs genannten Art anzugeben, die diese Nachteile nicht aufweist.

Die Aufgabe wird gelöst durch eine Schaltungsanordnung gemäß Patentanspruch 1. Ausgestaltungen und Weiterbildungen des Erfindungsgedankens sind Gegenstand von Unteransprüchen.

Bei der erfindungsgemäßen Schaltungsanordnung zum Erzeugen einer Hilfsgleichspannung aus einer Versorgungsspannung für einen ein hochfrequentes Nutzsignal führenden Schaltungsteil wird ein durch das hochfrequente Nutzsignal angesteuerter Spannungsumsetzer vorgesehen, dessen Arbeitsfrequenz gleich der Frequenz des hochfrequenten Nutzsignals ist.

Da bei der vorliegenden Erfindung die Arbeitsfrequenz des Spannungsumsetzers immer gleich dem hochfrequenten Nutzsignal ist, treten keine fremden Frequenzen und damit keine zusätzlichen Spektrallinien auf. Durch Fehlen dieser zusätzlichen Spektrallinien ist die Hilfsgleichspannung von hoher spektraler Reinheit. Ein der Hilfsgleichspannung überlagertes Wechselsignal hat nur die Frequenz des hochfrequenten Nutzsignals. Wird nun diese spektral sehr reine Hilfsgleichsspannung dem das hochfrequente Nutzsignal führenden Schaltungsteil zugeführt, dann werden außer gegebenenfalls einem nicht störenden Signal mit der Frequenz des hochfrequenten Nutzsignals keine weiteren Spektralanteile hinzugefügt. Somit sind keine aufwendigen Unterdrückungsmaßnahmen für unerwünschte Spektralanteile notwendig und die erfindungsgemäße Schaltungsanordnung ist somit auch für Anwendungen die höchste spektrale Reinheit erfordern wie etwa Leistungsverstärker für CDMA-Geräte (CDMA = Code Division Multiple Access) eingesetzt werden.

Je nach Ausgestaltung kann mit der erfindungsgemäßen Schaltungsanordnung sowohl die Versorgungsspannung vervielfacht werden, als auch eine Spannung mit entgegengesetzter Polarität gegenüber der Versorgungsspannung erzeugt werden. Schließlich hat die erfindungsgemäße Schaltungsanordnung darüber hinaus den Vorteil, daß aufgrund der Verwendung eines hochfrequenten Signals zur Hilfsgleichspannungserzeugung Schaltungselemente wie z.B. Blockkondensatoren so klein ausgeführt werden können, daß eine Integration in einen Chip möglich ist.

Ein bevorzugter Spannungsumsetzer weist eine Gleichrichteinheit auf, welche das hochfrequente Nutzsignal zur Erzeugung der Hilfsgleichspannung gleichrichtet. Damit wird mit wenig Aufwand unter Beibehaltung des spektralen und zeitlichen Verlaufs des hochfrequenten Nutzsignals die Hilfsgleichspannung erzeugt. Zur Erzeugung des gewünschten Betrags der Hilfsgleichspannung kann dabei mindestens eine Verstärkerstufe der Gleichrichteinheit vorgeschaltet werden.

Je nach Polung ermöglicht die Gleichrichteinheit mit geringem schaltungstechnischen Aufwand eine Spannungsvervielfachung und/oder eine Invertierung der Polarität der Versorgungsspannung ermöglicht. Derartige Gleichrichteinheiten bestehen im einfachsten Fall aus zwei Kondensatoren und zwei Dioden. Die beiden Kondensatoren sind dabei derart mit den Dioden verschaltet, daß einer der beiden Kondensatoren bei einer der Halbwellen eines Wechselspannungssignals geladen wird und bei der anderen Halbwelle zum Zwecke der Spannungsinvertierung spannungsmäßig umgedreht wird und dabei auf den zweiten Kondensator aufgeschaltet wird. Bei einer anderen Gleichrichteinheit wird während einer Halbwelle des Wechselsignals ein Kondensator aufgeladen, bei der anderen Halbwelle zum Wechselsignal zum Zwecke der Spannungsverdopplung addiert und dem zweiten Kondensator zugeführt.

Bevorzugte Gleichrichteinheiten zur Erzeugung einer entgegengesetzten Polarität der Hilfsgleichspannung gegenüber der Versorgungsgleichspannung weisen bevorzugt eine erste Kapazität auf, über die das Hochfrequenzsignal auf einen ersten Knotenpunkt eingespeist wird. Eine zweite Kapazität ist dabei zwischen einem Bezugspotential und einen zweiten Knotenpunkt geschaltet. Außerdem ist eine erste Diode zwischen den ersten und zweiten Knotenpunkt sowie eine zweite Diode zwischen den ersten Knotenpunkt und einen dritten Knotenpunkt geschaltet. Schließlich ist ein erster Widerstand zwischen zweiten und dritten Knotenpunkt und ein zweiter Widerstand zwischen dritten Knotenpunkt und den Eingang mindestens einer Verstärkerstufe geschaltet ist. Die Hilfsgleichspannung ist am zweiten Knotenpunkt abgreifbar. Die beiden Dioden bewirken dabei die Gleichrichtung, wobei die erste Kapazität zur Spannungsinvertierung und die zweite Kapazität zur Glättung des gleichgerichteten Signals dient.

Der das hochfrequente Nutzsignal führende Schaltungsteil kann einen Hochfrequenzverstärker aufweisen, dessen Eingangssignal das hochfrequente Nutzsignal bildet. Die Hilfsgleichspannung am Ausgang des Spannungsumsetzers kann beispielsweise zur Vorspannungserzeugung mindestens einer Stufe des Hochfrequenzverstärkers dienen.

Die Erfindung wird nachfolgend anhand der in den Figuren der Zeichnung dargestellten Ausführungsbeispiele näher erläutert. Es zeigt:
- Figur 1: eine erste, allgemeine Ausführungsform einer erfindungsgemäßen Schaltungsanordnung,
- Figur 2: eine Gleichrichteinheit zur Erzeugung einer inversen Spannung gegenüber der Versorgungsspannung bei dem Ausführungsbeispiel nach Figur 1 und
- Figur 3: eine Gleichrichteinheit zur Erzeugung einer Vielfachen der Versorgungsspannung bei der Schaltungsanordnung nach Anspruch 1,
- Figur 4: eine bevorzugte Ausführungsform einer erfindungsgemäßen Schaltungsanordnung.

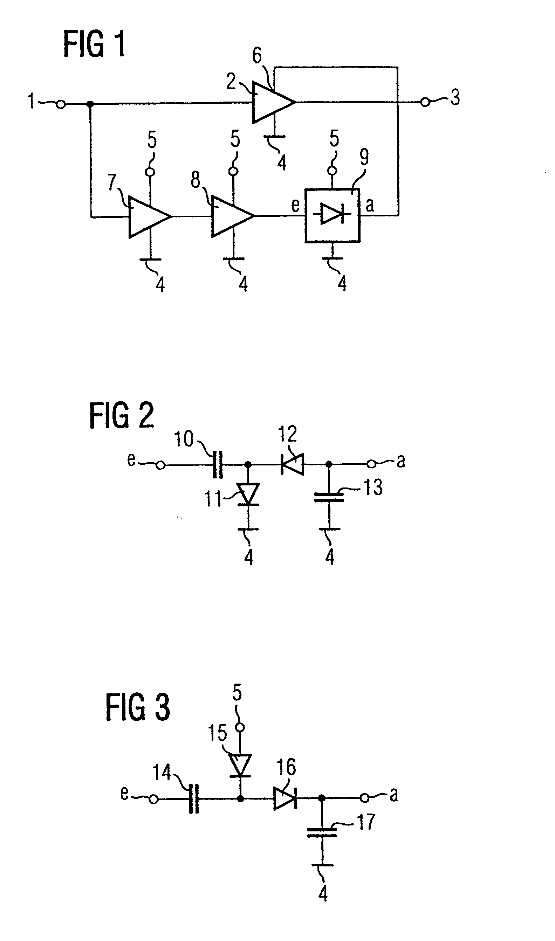

Bei dem allgemeinen Ausführungsbeispiel nach Figur 1 wird ein hochfrequentes Nutzsignal 1 einer Verstärkerschaltung 2 zugeführt und von dieser ein Ausgangssignal 3 bildend verstärkt. Beim vorliegenden Ausführungsbeispiel benötigt die Verstärkerschaltung 2 eine höhere Betriebsspannung als eine zur Verfügung stehende Versorgungsspannung, welche zwischen Masse 4 und einem Versorgungsanschluß 5 abgreifbar ist. Zur Erzeugung der höheren Betriebsspannung 6 wird das hochfrequente Nutzsignal 1 zwei hintereinander geschalteten Verstärkerstufen 7 und 8 zugeführt und durch diese verstärkt. Das verstärkte hochfrequente Nutzsignal 1 gelangt anschließend an den Eingang e einer Gleichrichteinheit 9, die daraus eine gegenüber der zwischen den Anschlüssen 4 und 5 abgreifbaren Versorgungsspannung doppelt so hohe, auf Masse 4 bezogene Hilfsgleichspannung 6 erzeugt. Anstelle einer Vielfachen der Versorgungsspannung 4, 5 kann ebenso durch entsprechende Wahl der Gleichrichteinheit 9 eine negative Hilfsgleichspannung erzeugt werden.

Figur 2 zeigt eine Gleichrichteinheit 9 zur Erzeugung einer negativen Hilfsgleichsspannung aus einer positiven Versorgungsspannung 4, 5. Der Eingang e der Gleichrichteinheit 9, an dem das verstärkte hochfrequente Nutzsignal 1 angelegt ist, wird über eine Kapazität 10 an einen Knotenpunkt geführt, der zum einen mit dem Anodenanschluß einer Diode 11 sowie mit dem Katodenanschluß einer Diode 12 verbunden ist. Der Katodenanschluß der Diode 11 ist dabei mit Masse 4 verschaltet. Die Anode der Diode 12 bildet zum einen den Ausgang a der Gleichrichteinheit 9 und ist zum anderen über eine Kapazität 13 ebenfalls mit Masse 4 gekoppelt. Die Kapazität 10 dient dabei zur Auskopplung des Wechselanteils in dem am Eingang e anliegenden Signal. Das Wechselsignal wird anschließend durch Dioden 11 und 12 gleichgerichtet. Zur Erzeugung einer Gleichspannung beispielsweise aus einer negativen Versorgungsspannung sind die Dioden 11 und 12 entsprechend umzupolen.

Figur 3 zeigt eine Ausgestaltung der Gleichrichteinheit 9 zur Erzeugung einer Vielfachen der Versorgungsspannung 6 an ihrem Ausgang a aus einem Signal aus Eingang e. Die Anodenanschlüsse zweier Dioden 15 und 16 sind dabei miteinander sowie über eine Kapazität 14 mit dem Eingang e gekoppelt. Der Katodenanschluß der Diode 15 ist mit dem Versorgungsanschluß 5 verbunden und der Anodenanschluß der Diode 16 ist über eine Kapazität 17 mit Masse 4 gekoppelt. Außerdem bildet der Anodenanschluß der Diode 16 den Ausgang a der Gleichrichteinheit 9, an dem eine gegenüber der Versorgungsspannung 4, 5 Betriebsspannung abgreifbar ist. Neben dem hier gezeigten Ausführungsbeispiel kann in gleicher Weise durch Umpolen der Dioden 15 und 16 eine verdoppelte negative Spannung am Eingang e aus einer negativen Versorgungsspannung gewonnen werden.

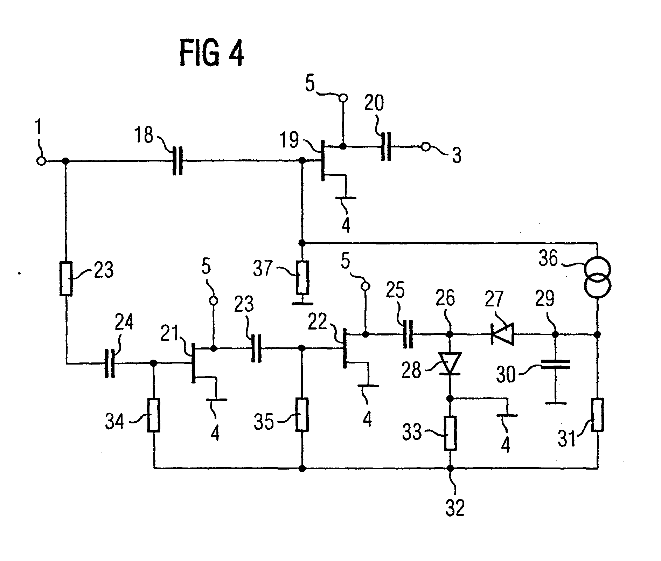

Bei dem bevorzugten Ausführungsbeispiel nach Figur 4 wird das hochfrequente Nutzsignal einem Höchstfrequenzverstärker zugeführt, der im wesentlichen einen Gallium-Arsenid-Mes-Feldeffekttransistor aufweist. Der Sourceanschluß des Feldeffekttransistors 19 ist mit Masse 4 verbunden und sein Drainanschluß ist beispielsweise unter Zwischenschaltung eines nicht gezeigten Widerstands mit der Versorgungsspannung 5 verschaltet. Die Einkopplung des hochfrequenten Nutzsignals erfolgt über einen Kondensator 18 auf den Gateanschluß des Feldeffekttransistors 19. Ausgangsseitig wird das verstärkte Signal am Drainanschluß des Feldeffekttransistors 19 abgenommen und über eine Kapazität 20 ausgekoppelt.

Zur Erzeugung einer negativen Spannung zur Verwendung als Vorspannung am Gate des Feldeffekttransistors 19 wird das hochfrequente Nutzsignal zwei hintereinandergeschalteten Verstärkerstufen zugeführt, die ebenfalls jeweils Gallium-Arsenid-Mes-Feldeffekttransistoren 21 und 22 aufweisen. Die Drain- und Source-Anschlüsse der Feldeffekttransistoren 21 und 22 sind in gleicher Weise wie der Feldeffekttransistor 19 an Masse 4 bzw. die Versorgungsspannung 5 angeschlossen. Die Einkopplung des hochfrequenten Nutzsignals an den Gateanschluß des Feldeffekttransistor 29 erfolgt dabei über einen Widerstand 23 und eine in Reihe dazu liegenden Kapazität 24 auf den Gateanschluß des Feldeffekttransistors 21. Die Kopplung der Feldeffekttransistoren 21 und 22 erfolgt mittels einer Kapazität 25, die zwischen den Sourceanschluß des Feldeffekttransistors 21 und den Gateanschluß des Feldeffekttransistors 22 geschaltet ist. Die Gleichrichteinheit, die dem Sourceanschluß des Feldeffekttransistors nachgeschaltet ist, umfaßt eine Kapazität 25, die zwischen den Sourceanschluß des Feldeffekttransistors 22 und einen Knotenpunkt 26 geschaltet ist. Der Knotenpunkt 26 ist mit der Katode einer Diode 27 sowie mit der Anode einer Diode 28 verbunden. Der Anodenanschluß der Diode 27 ist mit einem Knotenpunkt 29 verbunden, der darüber hinaus über eine Kapazität 30 mit Masse 4 sowie über einen Widerstand 31 mit einem Knotenpunkt 32 verschaltet ist und schließlich unter Zwischenschaltung einer Stromquelle 36 mit dem Gateanschluß des Feldeffekttransistors 19 gekoppelt ist zur Bereitstellung der negativen Vorspannung. Der Gateanschluß des Feldeffekttransistors 19 ist über einen Widerstand 37 mit Masse 4 gekoppelt. Stromquelle 36 und Widerstand 37 bilden zusammen einen Spannungsregler. Dabei kann unter Umständen beispielsweise die Stromquelle 36 auch durch einen Widerstand ersetzt werden. Der Katodenanschluß der Diode 28 ist ebenso wie ein Widerstand 33 mit Masse 4 verschaltet. Der andere Anschluß des Widerstands 33 ist mit dem Knotenpunkt 32 verbunden. Schließlich werden auch die Gateanschlüsse der Feldeffekttransistoren 21 und 22 mit einer negativen Vorspannung versorgt, indem ein Widerstand 34 bzw. 35 zwischen den Knotenpunkt 32 und den Gateanschluß des Feldeffekttransistors 21 bzw. 22 geschaltet ist.

## Patentansprüche

1. Schaltungsanordnung zum Erzeugen einer Hilfsgleichspannung (4, 6) aus einer Versorgungsgleichspannung (4, 5) für ein ein hochfrequentes Nutzsignal (1) verarbeitendes Schaltungsteil (2, 19) mit einem durch das hochfrequente Nutzsignal (1) angesteuerten Spannungsumsetzer (7, 8, 9, 21 bis 35), dessen Arbeitsfrequenz gleich der Frequenz des hochfrequenten Nutzsignals (1) ist und der Anschlüsse zum Anlegen der Versorgungsgleichspannung (4, 6) aufweist und durch den die Hilfsgleichspannung (4, 6) ausgangsseitig erzeugbar ist und in das Schaltungsteil (2, 19) eingekoppelt wird, wobei der Spannungsumsetzer (9) eine Kapazität (13, 17, 30) aufweist, die zwischen Masse (4) und einem zweiten Knotenpunkt (29) geschaltet ist, eine erste Diode (12, 16, 27), die zwischen dem zweiten Knotenpunkt (29) und einem ersten Knotenpunkt (26) geschaltet ist, und eine zweite Diode (11, 15, 28), die zwischen dem ersten Knotenpunkt (26) und einem der Anschlüsse für die Versorgungsgleichspannung (4, 5) geschaltet ist.

2. Schaltungsanordnung nach Anspruch 1, bei der die zweite Diode (11, 28) an Masse (4) angeschlossen ist und die Hilfsgleichspannung (4, 6) im Vergleich zur Versorgungsgleichspannung (5) eine entgegengesetzte Polarität aufweist.

3. Schaltungsanordnung nach Anspruch 1, bei der die zweite Diode (15) an die Versorgungsgleichspannung (5) angeschlossen ist und die Hilfsgleichspannung (4, 6) die gleiche Polarität und ein Vielfaches der Versorgungsgleichspannung (5) aufweist.

4. Schaltungsanordnung nach einem der Ansprüche 1 bis 3, bei der der Spannungsumsetzer eine Gleichrichteinheit (9; 25 bis 33) aufweist, welche das hochfrequente Nutzsignal (1) zur Erzeugung der Hilfsgleichspannung (4, 6) gleichrichtet.

5. Schaltungsanordnung nach Anspruch 4, bei der der Gleichrichteinheit (9; 25 bis 33) mindestens eine Verstärkerstufe (7, 8; 21 bis 25) vorgeschaltet ist.

6. Schaltungsanordnung nach Anspruch 5, sofern auf Anspruch 2 rückbezogen, bei der die Gleichrichteinheit (9) eine erste Kapazität (25) aufweist, über die das hochfrequente Nutzsignal (1) dem ersten Knotenpunkt (26) zugeführt wird, einen dritten Knotenpunkt (32), an den die zweite Diode (28) angeschlossen ist, einen ersten Widerstand (31), der zwischen den zweiten und den dritten Knotenpunkt (29, 32) geschaltet ist, und einen zweiten Widerstand (34, 35), der zwischen den dritten Knotenpunkt (32) und den Eingang mindestens eine der Verstärkerstufen geschaltet ist, wobei die Hilfsgleichspannung (4, 6) am zweiten Knotenpunkt (29) abgreifbar ist.

7. Schaltungsanordnung nach Anspruch 6, bei der in Reihe zur zweiten Diode (28) ein dritter Widerstand (33) geschaltet ist.

8. Schaltungsanordnung nach einem der vorhergehenden Ansprüche, bei der das hochfrequente Nutzsignal (1) das Eingangssignal eines Verstärkers ist, der in dem das hochfrequente Nutzsignal (1) führenden Schaltungsteil (2; 19) enthalten ist.

9. Schaltungsanordnung nach Anspruch 8, bei der die Gleichspannung (4, 6) am Ausgang des Spannungsumsetzers zur Vorspannungerzeugung einer das hochfrequente Nutzsignal (1) führenden Stufe (19) des Hochfrequenzverstärkers vorgesehen ist.

## Claims

1. Circuit arrangement for generating an auxiliary DC voltage (4, 6) from a DC supply voltage (4, 5) for a circuit component (2; 19) which processes a radio-frequency user signal (1) and has a voltage converter (7, 8, 9; 21 to 35) which is driven by the radio-frequency user signal (1) and whose operating frequency is the same as the frequency of the radio-frequency user signal (1) and which has terminals for applying the DC supply voltage (4, 6) and by means of which the auxiliary DC voltage (4, 6) can be generated on the output side and fed into the circuit component (2; 19), the voltage converter (9) having a capacitor (13, 17, 30) which is connected between earth (4) and a second node (29), a first diode (12, 16, 27) which is connected between the second node (29) and a first node (26), and a second diode (11, 15, 28) which is connected between the first node (26) and one of the terminals for the DC supply voltage (4; 5).

2. Circuit arrangement according to Claim 1, in which the second diode (11, 28) is connected to earth (4) and the auxiliary DC voltage (4, 6) is of opposite polarity to the DC supply voltage (5).

3. Circuit arrangement according to Claim 1, in which the second diode (15) is connected to the DC supply voltage (5) and the auxiliary DC voltage (4, 6) is of the same polarity as and is a multiple of the DC supply voltage (5).

4. Circuit arrangement according to one of Claims 1 to 3, in which the voltage converter has a rectifier unit (9; 25 to 33) which rectifies the radio-frequency user signal (1) to generate the auxiliary DC voltage (4, 6).

5. Circuit arrangement according to Claim 4, in which at least an amplifier stage (7, 8; 21 to 25) is connected upstream of the rectifier unit (9; 25 to 33).

6. Circuit arrangement according to Claim 5, referred back to Claim 2, in which the rectifier unit (9) has a first capacitor (25) via which the radio-frequency user signal (1) is fed to the first node (26), a third node (32) to which the second diode (28) is connected, a first resistor (31) which is connected between the second and third nodes (29, 32), and a second resistor (34, 35) which is connected between the third node (32) and the input of at least one of the amplifier stages, it being possible to tap the auxiliary DC voltage (4, 6) at the second node (29).

7. Circuit arrangement according to Claim 6, in which a third resistor (33) is connected in series with the second diode (28).

8. Circuit arrangement according to one of the preceding claims, in which the radio-frequency user signal (1) is the input signal of an amplifier which is contained in the circuit component (2; 19) which conducts the radio-frequency user signal (1).

9. Circuit arrangement according to Claim 8, in which the DC voltage (4, 6) is provided at the output of the voltage converter for generating the bias voltage of a stage (19) of the radio-frequency amplifier which conducts the radio-frequency user signal (1).

## Revendications

1. Montage de production d'une tension (4, 6) continue auxiliaire à partir d'une tension (4, 5) continue d'alimentation, pour une partie (2, 19) de circuit traitant un signal (9) utile de haute fréquence, comprenant un convertisseur (7, 8, 9, 21 à 35) de tension, qui est commandé par le signal (1) utile de haute fréquence, dont la fréquence de travail est égale à la fréquence du signal (1) utile de haute fréquence et qui a des bornes pour l'application de la tension (4, 6) continue d'alimentation, et par lequel la tension (4, 6) continue auxiliaire peut être produite du côté sortie et appliquée à la partie (2, 19) de circuit, le convertisseur (9) de tension ayant une capacité (13, 17, 30) qui est montée entre la masse (4) et un deuxième point (29) nodal, une première diode (12, 16, 27) qui est montée entre le deuxième point (29) nodal et un premier point (26) nodal et une deuxième diode (11, 15, 28) qui est montée entre le premier point (26) nodal et l'une des bornes pour l'application de la tension (4, 5) continue d'alimentation.

2. Montage suivant la revendication 1, dans lequel la deuxième diode (11, 28) est reliée à la masse (4) est la tension (4, 6) continue auxiliaire a par rapport à la tension (5) continue d'alimentation une polarité opposée.

3. Montage suivant la revendication 1, dans lequel la deuxième diode (15) est raccordée à la tension (5) continue d'alimentation et la tension (4, 6) continue auxiliaire a la même polarité que la tension (5) continue d'alimentation et en est un multiple.

4. Montage suivant l'une des revendications 1 à 3, dans lequel le convertisseur de tension a une unité (9, 25 à 33) de redressement, qui redresse le signal (1) utile de haute fréquence pour produire la tension (4, 6) continue auxiliaire.

5. Montage suivant la revendication 4, dans lequel il est monté en amont de l'unité (9, 25 à 33) de redressement au moins un étage (7, 8, 21, 25) amplificateur.

6. Montage suivant la revendication 5, dans la mesure où elle se rapporte à la revendication 2, dans lequel l'unité (8) de redressement comprend une première capacité (25) par laquelle le signal (1) utile de haute fréquence peut être appliqué au premier point (26) nodal, un troisième point (32) nodal auquel est reliée la deuxième diode (28), une première résistance (31) qui est montée entre le deuxième point (29) nodal et le troisième point (32) nodal et une deuxième résistance (34, 35) qui est montée entre le troisième point (32) nodal et l'entrée d'au moins l'un des étages amplificateurs, la tension (4, 6) continue auxiliaire pouvant être prélevée au deuxième point (29) nodal.

7. Montage suivant l'une des revendications précédentes, dans lequel il est monté en série à la deuxième diode (28) une troisième résistance (33).

8. Montage suivant l'une des revendications précédentes, dans lequel le signal (1) utile de haute fréquence est le signal d'entrée d'un amplificateur qui est contenu dans la partie (2,19) de circuit dans laquelle passe le signal (1) utile de haute fréquence.

9. Montage suivant la revendication 8, dans lequel la tension (4,6) continue à la sortie du convertisseur de tension est prévue pour la production d'une tension de polarisation d'un étage (19) de l'amplificateur haute fréquence dans lequel passe le signal (1) utile de haute fréquence.
